# EUROPÄISCHE PATENTSCHRIFT

(11) **EP 1 525 631 B1**
(45) Veröffentlichungstag und Bekanntmachung des Hinweises auf die Patenterteilung: **19.12.2007**
(21) Anmeldenummer: 03787668.7
(22) Anmeldetag: 15.07.2003
(51) Int. Cl.: H01L 51/05, H01L 51/40

(54) **VERRINGERUNG DES KONTAKTWIDERSTANDES IN ORGANISCHEN FELDEFFEKTTRANSISTOREN DURCH VERWENDUNG VON PHOSPHINEN UND METALLHALTIGEN PHOSPHINEN**
REDUCTION OF THE CONTACT RESISTANCE IN ORGANIC FIELD EFFECT TRANSISTORS BY THE USE OF PHOSPHINES AND PHOSPHINES CONTAINING METAL
REDUCTION DE LA RESISTIVITE DE CONTACT DANS LES TRANSISTORS A EFFET DE CHAMP ORGANIQUES PAR L'UTILISATION DE PHOSPHINES ET DE PHOSPHINES METALLIFERES

(30) Priorität: 31.07.2002 DE 10234997
(43) Veröffentlichungstag der Anmeldung: 27.04.2005
(73) Patentinhaber: Qimonda AG, 81739 München (DE)
(72) Erfinder: KLAUK, Hagen, 70195 Stuttgart (DE); SCHMID, Günter, 91334 Hemhofen (DE); ZSCHIESCHANG, Ute, 70195 Stuttgart (DE); HALIK, Marcus, 91058 Erlangen (DE); TERZOGLU, Efstratios, 91126 Rednitzhembach (DE)
(74) Vertreter: Kottmann, Heinz Dieter
(86) Internationale Anmeldenummer: PCT/DE2003/002379
(87) Internationale Veröffentlichungsnummer: WO 2004/017440

(56) Entgegenhaltungen:
- WO-A-01/01502
- DE-A- 10 116 876
- US-B1- 6 335 539

## Beschreibung

Die Erfindung betrifft eine Halbleitereinrichtung mit einer Halbleiterstrecke aus einem organischen Halbleitermaterial, einem ersten Kontakt zum Injizieren von Ladungsträgern in die Halbleiterstrecke und einem zweiten Kontakt zum Extrahieren von Ladungsträgern aus der Halbleiterstrecke, sowie ein Verfahren zur Herstellung einer solchen Halbleitereinrichtung.

Halbleiterchips haben eine breite Verwendung in vielfältigen technischen Anwendungen gefunden. Ihre Herstellung ist jedoch noch immer sehr aufwändig und teuer. Siliziumsubstrate können zwar bis auf sehr geringe Schichtdicken gedünnt werden, so dass sie flexibel werden. Diese Verfahren sind jedoch ebenfalls sehr teuer, so dass flexible oder gekrümmte Mikrochips nur für anspruchsvolle Anwendungen geeignet sind, bei denen erhöhte Kosten in Kauf genommen werden können. Die Verwendung organischer Halbleiter bietet die Möglichkeit einer kostengünstiger Herstellung mikroelektronischer Halbleiterschaltungen auf flexiblen Substraten. Eine Anwendung ist zum Beispiel eine dünne Folie mit integrierten Steuerelementen für Flüssigkristallbildschirme. Ein weiteres Anwendungsfeld ist die Transpondertechnologie, wo auf so genannten Tags zum Beispiel Informationen über eine Ware gespeichert sind.

Feldeffekttransistoren werden als Schalter in elektronischen Schaltkreisen eingesetzt. Dabei wirkt jeweils ein zwischen einer jeweils aus einem elektrisch leitfähigen Material aufgebauten Source- und einer Drainelektrode angeordneter Halbleiter im ausgeschalteten Zustand des Transistors als Isolator, während sich unter dem Einfluss des Feldes einer Gateelektrode im eingeschalteten Zustand des Transistors ein Ladungsträgerkanal ausbildet. Dabei werden am Sourcekontakt elektrische Ladungsträger in die Halbleiterschicht injiziert und am Drainkontakt aus der Halbleiterschicht extrahiert, so dass von Source nach Drain ein elektrischer Strom durch die Halbleiterschicht bzw. durch den in der Halbleiterschicht erzeugten Ladungskanal fließt.

Wegen der, unterschiedlichen Fermi-Niveaus von Halbleitermaterial und Kontaktmaterial kommt es an der Kontaktfläche der beiden Materialien zu einem asymmetrischen Diffusionsprozess der Ladungsträger. Durch die unterschiedliche Energie der Fermi-Niveaus der beiden Materialien besteht eine Energiedifferenz, die durch den Übertritt von Ladungsträgern ausgeglichen wird. Als Folge baut sich ein Grenzflächenpotential auf, das beim Anlegen einer äußeren Potentialdifferenz einem Übertritt der Ladungsträger zwischen den beiden Schichten entgegenwirkt. Es entsteht also eine Potentialbarriere, die von den Ladungsträgern beim Eintritt vom elektrisch leitfähigen Kontakt in das Halbleitermaterial bzw. beim Austritt aus dem Halbleitermaterial in den elektrisch leitfähigen Kontakt überwunden werden muss. Der Tunnelstrom, welcher durch ein Durchtunneln der Ladungsträger durch die Potentialbarriere entsteht, ist dabei um so geringer, je höher bzw. breiter die Potentialbarriere ist. Ein niedriger Tunnelstrom entspricht einem hohen Kontaktwiderstand. Bei Halbleiterbauelementen auf der Basis anorganischer Halbleiter begegnet man einer Erhöhung des Kontaktwiderstandes durch eine Dotierung des anorganischen Halbleiters in einer zur Kontaktfläche orientierten Grenzschicht. Durch die Dotierung wird die Energie des Fermi-Niveaus im anorganischen Halbleiter verändert, das heißt die Differenz zwischen den Fermi-Niveaus von Kontaktmaterial und Halbleitermaterial verringert sich. Als Folge kommt es entweder zu einer Verringerung der Potentialbarriere, wodurch es einer wesentlich größeren Anzahl von Ladungsträgern möglich wird, die Potentialbarriere zu überwinden und das gegenüberliegende Material zu überschwemmen, oder zu einer Schmälerung der Potentialbarriere, wodurch sich die Wahrscheinlichkeit für ein Tunneln von Ladungsträgern durch die Potentialbarriere erhöht. In beiden Fällen verringert sich der Kontaktwiderstand.

Bei der Herstellung von Feldeffekttransistoren auf der Basis von amorphen oder polykristallinen Siliziumschichten erfolgt die Dotierung der Kontaktbereiche durch das Einbringen von Phosphor oder Bor in die Siliziumschicht nahe der Source- und Drainkontakte. Die Phosphor-oder Boratome werden in das Siliziumnetzwerk eingebaut und wirken als Ladungsdonatoren oder Ladungsakzeptoren, wodurch sich die Dichte der freien Ladungsträger und damit die elektrische Leitfähigkeit des Siliziums im dotierten Bereich erhöht. Dies bewirkt eine Verringerung der Differenz zwischen den Fermi-Niveaus von Kontaktmaterial und dotiertem Halbleitermaterial. Die Dotiersubstanz wird dabei nur im Bereich der Source- und Drainkontakte in das Silizium eingebracht, nicht aber in der Kanalregion, in welcher sich unter dem Einfluss des Feldes der Gateelektrode ein Ladungsträgerkanal ausbildet. Da Phosphor und Bor kovalente Bindungen mit dem Silizium eingehen, besteht keine Gefahr der Diffusion dieser Atome in die Kanalregion, so dass eine geringe elektrische Leitfähigkeit in der Kanalregion weiterhin sichergestellt ist.

Ist die Dotierung der Kontaktbereiche genügend hoch, ist die Tunnelwahrscheinlichkeit bereits im Ruhezustand so groß, dass der Übergang zwischen dem Kontaktmaterial und dem anorganischen Halbleitermaterial seine Sperrfähigkeit verliert und in beiden Richtungen gut leitend wird.

Feldeffekttransistoren auf der Basis organischer Halbleiter sind für eine Vielzahl elektronischer Anwendungen von Interesse, die extrem niedrige Fertigungskosten, flexible oder unzerbrechliche Substrate, oder die Herstellung von Transistoren und integrierten Schaltungen über große aktive Flächen erfordern. Zum Beispiel eignen sich organische Feldeffekttransistoren als Pixelsteuerelemente in Aktiv-Matrix-Bildschirmen. Solche Bildschirme werden gewöhnlich mit Feldeffekttransistoren auf der Basis amorpher oder polykristalliner Siliziumschichten hergestellt. Die für die Herstellung hochwertiger Transistoren auf der Basis amorpher oder polykristalliner Siliziumschichten notwendigen Temperaturen von gewöhnlich mehr als 250°C erfordern die Verwendung starrer und zerbrechlicher Glas- oder Quarzsubstrate. Dank der relativ niedrigen Temperaturen, bei denen Transistoren auf der Basis organischer Halbleiter hergestellt werden, von gewöhnlich weniger als 100°C, erlauben organische Transistoren die Herstellung von Aktiv-Matrix-Bildschirmen unter Verwendung billiger, flexibler, transparenter, unzerbrechlicher Polymerfolien mit erheblichen Vorteilen gegenüber Glas oder Quarzsubstraten.

Ein weiteres Anwendungsgebiet für organische Feldeffekttransistoren liegt in der Herstellung von sehr preiswerten integrierten Schaltungen, wie sie zum Beispiel für die aktive Kennzeichnung und Identifizierung von Waren und Gütern zum Einsatz kommen. Diese so genannten Transponder werden gewöhnlich unter Verwendung von integrierten Schaltkreisen auf der Basis von einkristallinem Silizium hergestellt, was zu erheblichen Kosten bei der Aufbau- und Verbindungstechnik führt. Die Herstellung von Transpondern auf der Grundlage organischer Transistoren würde zu enormen Kostensenkungen führen und könnte der Transpondertechnologie zum weltweiten Durchbruch verhelfen.

Eines der Hauptprobleme bei der Anwendung organischer Feldeffekttransistoren sind die relativ schlechten elektrischen Eigenschaften der Source- und Drainkontakte, das heißt deren hohe Kontaktwiderstände. Die Source- und Drainkontakte organischer Transistoren werden meist unter Verwendung anorganischer Metalle oder mit Hilfe leitfähiger Polymere erzeugt, um so eine möglichst hohe elektrische Leitfähigkeit der Kontakte zu gewährleisten. Die meisten organischen Halbleiter, die für die Verwendung in organischen Feldeffekttransistoren in Frage kommen, besitzen sehr geringe elektrische Leitfähigkeiten. Zum Beispiel weist Pentazen, das häufig für die Herstellung organischer Feldeffekttransistoren verwendet wird, eine sehr geringe elektrische Leitfähigkeit von 10⁻¹⁴ Ω⁻¹cm⁻¹ auf. Besitzt der organische Halbleiter eine geringe elektrische Leitfähigkeit, besteht daher an der Kontaktfläche eine große Differenz zwischen den Fermi-Niveaus von elektrisch leitendem Kontaktmaterial und organischem Halbleitermaterial. Dies führt zur Ausbildung einer hohen Potentialbarriere mit einer geringen Tunnelwahrscheinlichkeit für den Durchtritt von Ladungsträgern. Source- und Drainkontakte weisen daher oft hohe Kontaktwiderstände auf, weshalb hohe elektrische Feldstärken an den Kontakten erforderlich sind, um Ladungsträger zu injizieren und zu extrahieren. Beschränkend wirkt also nicht die Leitfähigkeit des Kontaktes selbst, sondern die geringe Leitfähigkeit der an die Kontakte angrenzenden Halbleiterbereiche, in welche die Ladungsträger injiziert bzw. aus welchen die Ladungsträger extrahiert werden.

Um die elektrischen Eigenschaften der Source- und Drainkontakte zu verbessern, ist deshalb eine hohe elektrische Leitfähigkeit des organischen Halbleiters in den an die Kontakte angrenzenden Bereichen erwünscht, um den Unterschied in den Fermi-Niveaus zwischen organischem Halbleiter und Kontaktmaterial zu verringern und damit die Kontaktwiderstände zu erniedrigen. Andererseits hat eine hohe elektrische Leitfähigkeit des organischen Halbleiters in der Kanalregion einen negativen Einfluss auf die Eigenschaften des Transistors. Eine nennenswerte elektrische Leitfähigkeit in der Kanalregion führt unweigerlich zu hohen Leckströmen, das heißt zu relativ hohen elektrischen Stromstärken im ausgeschalteten Zustand des Feldeffekttransistors. Für viele Anwendungen sind aber niedrige Leckströme im Bereich von 10⁻¹² A oder weniger unabdingbar. Eine hohe elektrische Leitfähigkeit führt außerdem dazu, dass das Verhältnis zwischen maximalem Einschaltstrom und minimalem Ausschaltstrom zu gering ausfällt. Viele Anwendungen erfordern ein möglichst großes Verhältnis zwischen Einschaltstrom und Ausschaltstrom im Bereich von 10⁷ oder größer, da dieses Verhältnis das Modulationsverhalten und die Verstärkung des Transistors widerspiegelt. In der Kanalregion ist daher eine geringe elektrische Leitfähigkeit des organischen Halbleiters erforderlich, während im Bereich der Source- und Drainkontakte eine hohe elektrische Leitfähigkeit notwendig ist, um die Kontakteigenschaften zwischen organischem Halbleitermaterial und dem Material der Kontakte zu verbessern.

Die elektrische Leitfähigkeit vieler organischer Halbleiter kann wie bei anorganischen Halbleitern durch das Einbringen geeigneter Dotiersubstanzen erhöht werden. Die Erzielung positioneller Selektivität beim Dotieren ist jedoch problematisch. Die Dotiersubstanzen sind in den organischen Halbleitern nicht an eine bestimmte Position gebunden und können sich innerhalb des Materials frei bewegen. Selbst wenn der Dotierungsprozess ursprünglich auf einen bestimmten Bereich, zum Beispiel die Bereiche um die Source- und Drainkontakte, beschränkt werden kann, kommt es später zu einer Wanderung der Dotiersubstanzen durch die gesamte organische Halbleiterschicht, insbesondere unter dem Einfluss des elektrischen Feldes, das zwischen dem Source- und Drainkontakt angelegt wird, um den Transistor zu betreiben. Durch die Diffusion der Dotiersubstanz innerhalb der organischen Halbleiterschicht erhöht sich unweigerlich die elektrische Leitfähigkeit in der Kanalregion.

I. Kymissis, C. D. Dimitrakopoulos und S. Purushothaman, "High-Performance Bottom Electrode Organic Thin-Film Transistors" IEEE Transactions on Electron Devices, Vol. 48, Nr. 6, Juni 2001, S. 1060 - 1061 beschreiben eine Halbleitereinrichtung mit vermindertem Kontaktwiderstand, wobei auf Chrom/Gold-Elektroden zunächst eine monomolekulare Schicht aus 1-Hexadecanthiol und auf dieser dann eine Schicht aus Pentazen als organisches Halbleitermaterial aufgebracht wird. Diese Anordnung ermöglicht es, den Kontaktwiderstand für den Ladungsübertritt der Ladungsträger zwischen Elektrode und Halbleiterstrecke wesentlich zu erniedrigen. Die an der Grenzfläche zwischen Kontakt und organischem Halbleiter angeordneten Moleküle aus 1-Hexadecanthiol wirken als Ladungstransfer-Moleküle. Sie stehen sowohl mit dem Kontaktmaterial als auch mit der organischen Halbleiterschicht in direktem Kontakt. Wegen ihrer molekularen Struktur können die Ladungstransfer-Molekül einen Transfer von Ladungsträgern zwischen dem Kontaktmaterial, in dem ein Überschuss an Ladungsträgern besteht, und der organischen Halbleiterschicht, in der ein Mangel an Ladungsträgern besteht, erzwingen. Auf diese Weise kann im Bereich der Source- und Drainkontakte ein Ladungsträgerüberschuss in der organischen Halbleiterschicht herbeigeführt werden, wodurch der Kontaktwiderstand deutlich verringert wird. Die Thiolgruppen des 1-Hexadecanthiols bilden eine kovalente Bindung zur Oberfläche der Goldkontakte aus, was eine lokale Fixierung der Moleküle bewirkt. Auch unter Einwirkung eines zwischen Source- und Drainelektrode angelegten Feldes wandern die Ladungstransfermoleküle daher nicht in diejenigen Abschnitte der organischen Halbleiterstrecke, in welcher die Kanalregion ausgebildet wird.

Gold hat jedoch den Nachteil, dass es meist sehr schlecht auf anorganischen Schichten haftet, wie zum Beispiel auf Siliziumdioxid. Um die Haftung der Goldkontakte zu verbessern, wird daher unmittelbar vor der Abscheidung der Goldschicht oft eine dünne Schicht aus Chrom oder Titan als Haftvermittler aufgebracht. Dies hat jedoch den Nachteil, dass die für die Erzeugung der Kontaktstrukturen notwendige Strukturierung der Metallschicht erschwert wird. Ferner eignen sich Thiole auch nur für bestimmte Metalle, wie Gold, als Ladungstransfermoleküle, da nicht zu allen Metallen, die für die Herstellung von Kontakten geeignet sind, eine ausreichende Bindungsstärke erreicht werden kann, um ein Abdiffundieren der Thiole aus der Grenzschicht zwischen Kontakt und Halbleitermaterial zu verhindern.

Aufgabe der Erfindung ist es daher, eine Halbleitereinrichtung mit einer Halbleiterstrecke aus einem organischen Halbleitermaterial, einem ersten Kontakt zum Injizieren von Ladungsträgern in die Halbleiterstrecke und einem zweiten Kontakt zum Extrahieren von Ladungsträgern aus der Halbleiterstrecke zur Verfügung zu stellen, welche einen niedrigen Kontaktwiderstand für den Übertritt von Ladungsträgern zwischen Kontakt und Halbleiterstrecke aufweist.

Die Aufgabe wird bei einer Halbleitereinrichtung der oben genannten Art gelöst, indem zwischen erstem Kontakt und der Halbleiterstrecke und/oder zwischen zweitem Kontakt und der Halbleiterstrecke eine monomolekulare Schicht eines Phosphins angeordnet ist.

Phosphine können mit einer großen Anzahl von Metallen, welche als Material für Kontakte in dem oben beschriebenen Halbleitereinrichtungen verwendet werden, äußerst stabile Komplexe ausbilden. Wird das Phosphin auf die Fläche der Kontakte aufgebracht, welche später die Kontaktfläche zur Halbleiterstrecke bildet, werden die Moleküle daher unter Ausbildung eines Komplexes an die Oberfläche koordiniert. Dies sichert einerseits einen guten Kontakt zum Material der Kontakte und andererseits eine Fixierung der Phosphinmoleküle an der Kontaktfläche, so dass diese in einem Feld, das zwischen Source- und Drainelektrode angelegt wird, nicht in die Abschnitte der Halbleiterstrecke diffundieren, in welchen der Leitungskanal ausgebildet wird.

Als Halbleiterstrecke wird eine Leitungsstrecke zwischen zwei Kontakten bezeichnet, welche aus einem organischen Halbleitermaterial aufgebaut ist. Die Ladungsträger, Elektronen bzw. Löcher, werden am ersten Kontakt in die Halbleiterstrecke injiziert, durchlaufen die Halbleiterstrecke und werden am zweiten Kontakt wieder aus der Leiterstrecke extrahiert. Als organisches Halbleitermaterial können an sich alle organischen Materialien verwendet werden, welche Halbleitereigenschaften aufweisen. Beispiele für geeignete Verbindungen sind kondensierte Aromaten, wie Antrazen, Tetrazen oder Pentazen, polymere aromatische Verbindungen, wie Polyvinylene oder Polynaphthalinderivate, elektrisch halbleitende Verbindungen auf der Basis von Polythiophen, zum Beispiel Poly-3-hexylthiophen-2,5-diyl, oder elektrisch halbleitende Verbindungen auf der Basis von Polyvinylthiophen oder Polyanilin. Neben den genannten Verbindungen können auch andere organische Halbleiterverbindungen verwendet werden. Die organischen Halbleitermaterialien können eine Dotierung aufweisen. Dabei sollte jedoch sichergestellt sein, dass die Dotierung nicht im organischen Halbleitermaterial wandert bzw. diffundiert. Die Halbleiterstrecke kann homogen aus nur einem organischen Halbleitermaterial bestehen. Es ist aber auch möglich, eine Halbleiterstrecke vorzusehen, die aus verschiedenen Abschnitten besteht, die aus jeweils verschiedenen organischen Halbleitermaterialien aufgebaut sind.

Die für die Herstellung der Halbleiterstrecke der erfindungsgemäßen Halbleitereinrichtung verwendeten Materialien sind einfach zugänglich und können teilweise auch von kommerziellen Anbietern bezogen werden. Die organischen Halbleitermaterialien bzw. Vorstufen für die Herstellung der organischen Halbleitermaterialien sind meist in organischen Lösungsmitteln gut löslich und können daher in gelöster Form bzw. als Suspension bereitgestellt und in flüssiger Form auf ein Substrat aufgebracht werden. Auf diese Weise kann die Halbleiterstrecke der erfindungsgemäßen Halbleitervorrichtung beispielsweise durch einfache Druckverfahren erzeugt werden, was die Herstellung des Halbleiterelements wesentlich vereinfacht und verbilligt. Die Abscheidung des organischen Halbleitermaterials kann jedoch auch nach anderen Verfahren erfolgen, beispielsweise durch Aufsublimieren des Halbleitermaterials aus der Gasphase.

Als Material für die Kontakte sind alle Materialien geeignet, welche eine ausreichend hohe elektrische Leitfähigkeit aufweisen. Prinzipiell sind alle Metalle geeignet, vorzugsweise Palladium, Gold, Platin, Nickel, Kupfer, Aluminium, wie auch elektrisch leitfähige Oxide, wie zum Beispiel Rutheniumoxid und Indiumzinnoxid, sowie auch elektrisch leitfähige Polymere, wie Polyacetylen oder Polyanilin. Das Material für die Kontakte sollte zum Phosphin eine stabile Bindung ausbilden können, um das Phosphin an die Oberfläche zu binden. Metalle bilden mit Phosphinen im Allgemeinen stabile Komplexe, weshalb die Kontakte bevorzugt aus Metallen aufgebaut sind.

Der erste und/oder der zweite Kontakt der Halbleitereinrichtung ist vorzugsweise aus Palladium aufgebaut. Palladium zeichnet sich wie Gold durch eine ausgezeichnete Oxidationsbeständigkeit aus und ist ebenfalls leicht abzuscheiden und zu strukturieren. Im Gegensatz zu Gold haftet Palladium jedoch wesentlich besser auf Unterlagen aller Art, so dass die zusätzliche Verwendung eines Haftvermittlers, wie Chrom oder Titan, nicht erforderlich ist. Phosphine zeigen eine sehr gute Haftung auf Palladiumoberflächen, so dass keine Wanderung dieser Verbindungen im elektrischen Feld erfolgt. Werden Phosphine auf Palladium aufgebracht, kommt es zur Bildung eines stabilen Metallkomplexes und damit zur Fixierung der Moleküle auf der Palladiumoberfläche durch Komplexbildung. Thiole sind für die Fixierung auf Palladium ungeeignet, da die Palladium-Schwefel-Bindung im Vergleich zur Gold-Schwefel-Bindung deutlich schwächer ist und keine lokale Fixierung der Moleküle auf der Kontaktoberfläche erfolgt.

Um einen möglichst geringen Kontaktwiderstand für den Übertritt der Ladungsträger zwischen Kontakt und Halbleiterstrecke zu erreichen, sollte die Schicht des Phosphins möglichst dünn ausgeführt werden. Bevorzugt ist die Schicht des Phosphins als selbstorganisierende monomolekulare Schicht ausgebildet. In diesem Fall wird die Oberfläche des Kontakts mit einer monomolekularen Schicht belegt, wobei das Phosphin über den Phosphor an die Oberfläche des Kontakts koordiniert wird. Ist die Oberfläche des Kontakts vollständig belegt, wird keine weitere Verbindung mehr adsorbiert und überschüssiges Phosphin kann beispielsweise mit einem geeigneten Lösungsmittel weggespült werden.

Die für die erfindungsgemäße Halbleitereinrichtung geeigneten Phosphine können eine äußerst vielfältige Struktur aufweisen. Der für den Übertritt der Ladungsträger zwischen Kontakt und Halbleiterstrecke herrschende Kontaktwiderstand kann durch Variation der Struktur des Phosphins in weiten Grenzen verändert und auf die Materialien, z.B. der Halbleiterstrecke abgestimmt werden. Geeignet sind bereits vergleichsweise einfach aufgebaute Phosphine, wie PH₃ oder PF₃. Weiter eignen sich Alkylphosphine, wobei die an den Phosphor gebundenen Alkylgruppen gleich oder verschieden sein können und vorzugsweise 1 bis 20, insbesondere bevorzugt 1 bis 8 Kohlenstoffatome umfassen. Beispiele für geeignete Alkylgruppen sind Methyl-, Ethyl- Propyl- Butyl-, Pentyl-, Hexyl-, Heptyl- und Octylgruppen, wobei diese Gruppen geradkettig oder verzweigt sein können. Geeignet sind auch zyklische Alkylgruppen, wie z.B. Cyclopentyl- oder Cyclohexylgruppen. Die Alkylgruppen können auch ein oder mehrere Kohlenstoff-Kohlenstoff-Doppelbindungen enthalten, die isoliert oder konjugiert zueinander angeordnet sein können. Beispiel für eine geeignete ungesättigte Alkylgruppe (Alkenylgruppe) ist die Vinylgruppe. In den genannten Gruppen können auch ein oder mehrere Wasserstoffatome durch Halogenatome, wie Fluor, oder Pseudohalogenide, wie eine Nitrilgruppe, ersetzt sein. Auch andere Gruppen sind geeignet, z.B. eine Aminogruppe. Beispiele für geeignete Phosphine sind Tris(2-cyanoethyl)phosphin oder Tris(diethylamino)phosphin. Geeignet sind ferner A-rylphosphine, wobei die Arylgruppe beispielsweise ausgewählt wird aus der Gruppe, die gebildet ist aus Phenyl, Anisyl, p-Methylphenyl, p-Sulfonsäurephenyl. Die an den Phosphor gebundenen Arylgruppe können gleich oder verschieden sein. Ein Beispiel für ein geeignetes Arylphosphin ist Diphenylphosphinobenzoesäure. Auch in den Arylgruppen können ein oder mehrere der Wasserstoffatome durch Halogenatome oder Pseudohalogenide ersetzt sein. Beispiele für derartige Arylgruppen sind Fluorphenyl oder Perfluorphenyl. Weiter sind auch chelatisierende Phosphine mit zwei oder mehreren Phosphinsubstituenten geeignet, wie 1,2-bis-(Diphenylphosphino)ethan, cis-1,2-bis-(Diphenylphosphino)ethylen, bis-(Diphenylphosphino)methan, 1,1,1-Tris(diphenylphosphinomethyl)ethan, Bis(dimethylphosphino)methan. Ferner können auch Phosphine verwendet werden, die sowohl Alkyl-, wie auch Arylgruppen umfassen.

Phosphine bilden sehr stabile Komplexe mit Metallen, insbesondere Palladium und Platin aus. In Lösung stellt sich ein reversibles Gleichgewicht ein:

Pd(PPh₃)₄ ↔ Pd(PPh₃)₃ + PPh₃ ↔ Pd(PPh₃)₂ + 2 PPh₃

Dieses Gleichgewicht ermöglicht die Ausbildung einer Metall-Metall-Bindung. Für diese Umsetzung sind Komplexe wie Pd(PPh₃)₄ oder Pd(CO)(PPh₃)₃ geeignet. Auf diese Weise lassen sich aber auch gezielt Komplexe aufbringen, die andere Metalle enthalten als das Metall des Kontaktes. Geeignet sind beispielsweise Komplexe von Platin oder Nickel. Beispiele für geeignete Komplexe sind Pt(PPh₃)₄ oder Pt (CO) (PPh₃)₃ oder auch NiCl₂(dppe)₂. Auf diese Weise lassen sich auch Fremdmetalle in die Kontaktfläche zwischen Kontakt und Halbleiterstrecke einführen.

Die erfindungsgemäße Halbleiteranordnung lässt sich sehr einfach in komplexere Bauelemente integrieren. So wird in einer besonders bevorzugten Ausführungsform die oben beschriebene Halbleitereinrichtung durch eine Gateelektrode und ein Gatedielektrikum zu einem Transistor ergänzt. Der erste Kontakt der Halbleitereinrichtung bildet dann den Sourcekontakt, während der zweite Kontakt die Drainelektrode bildet. Unter dem Einfluss des von der Gateelektrode erzeugten Feldes wird dann zwischen Source- und Drainelektrode ein Ladungskanal ausgebildet, in welchem ein Ladungsträgertransport stattfindet. Für die Gateelektrode können die gleichen Materialien verwendet werden, wie sie weiter oben für den ersten und zweiten Kontakt beschrieben worden sind. Zur Isolation der Gateelektrode können übliche Materialien verwendet werden, wie Siliziumdioxid, Aluminiumoxid oder ein isolierendes Polymer, wie Polystyrol, Polyethylen, Polyester, Polyurethan, Polycarbonat, Polyacrylat, Polyimid, Polyether, Polybenzoxazole oder Gemische dieser Verbindungen.

Das erfindungsgemäße Halbleiterelement lässt sich sehr kostengünstig aus gut zugänglichen Materialien herstellen und eignet sich daher insbesondere für eine Anwendung in Vorrichtungen, welche einem hohen Kostendruck unterliegen, wie zum Beispiel RF-ID-Etiketten für die Kennzeichnung von Waren.

Gegenstand der Erfindung ist daher auch ein Verfahren zur Herstellung der oben beschriebenen Halbleitereinrichtung, wobei auf einem Substrat ein erster und/oder ein zweiter Kontakt bereitgestellt wird, welcher eine freiliegende Kontaktfläche aufweist. Auf der freiliegenden Kontaktfläche wird ein Phosphin oder ein metallhaltiges Phosphinderivat aufgebracht, so dass auf der Kontaktfläche eine Schicht des Phosphins erhalten wird. Schließlich wird ein organisches Halbleitermaterial in der Weise abgeschieden, dass zwischen erstem Kontakt und zweitem Kontakt eine Halbleiterstrecke aus dem organischen Halbleitermaterial erhalten wird.

Als Substrat können bei der Herstellung der erfindungsgemäßen Halbleitereinrichtung unflexible Substrate verwendet werden, wie zum Beispiel Träger aus Glas oder Quarz oder auch Siliziumwafer. Bevorzugt werden jedoch flexible Substrate verwendet, wie zum Beispiel Kunststofffolien aus zum Beispiel Polystyrol, Polyethylen, Polyester, Polyurethan, Polycarbonat, Polyacrylat, Polyimid, Polyether oder Polybenzoxazolen oder auch Papier. Auf dem Substrat können auch bereits Bauelemente der Halbleitereinrichtung definiert sein, wie zum Beispiel eine Gateelektrode, welche mit einem entsprechenden Gatedielektrikum isoliert ist. Anschließend werden auf dem Substrat der erste und zweite Kontakt definiert, wobei übliche Methoden für die Abscheidung und Strukturierung verwendet werden. Das Metall, aus welchem die Kontakte aufgebaut sind, kann beispielsweise durch Elektronenstrahlverdampfen oder mittels Kathodenstrahlzerstäubung abgeschieden werden. Andere Verfahren können jedoch ebenfalls angewandt werden. Die Metallschicht wird anschließend strukturiert, beispielsweise durch fotolithografische Verfahren. Das Phosphin wird anschließend auf die Kontakte aufgebracht, wobei hier an sich beliebige Verfahren verwendet werden können. So kann das Phosphin beispielsweise aus der Gasphase aufgebracht werden, indem ein mit dem Phosphin gesättigter Luftstrom über die Oberfläche der Kontakte geleitet wird, so dass die Phosphinmoleküle an der Oberfläche des Kontakts gebunden werden. Bevorzugt wird das Phosphin jedoch als Lösung auf die Kontakte aufgebracht. Dies ist insbesondere dann vorteilhaft, wenn das Phosphin einen sehr niedrigen Dampfdruck aufweist. Dazu wird zunächst eine Lösung des Phosphins in einem geeigneten Lösungsmittel hergestellt und dieses dann auf die Kontakte aufgebracht. Durch Diffusion wandern die Moleküle aus der Lösung an die Oberfläche der Kontakte, wo die Moleküle über den Phosphor unter Ausbildung eines Metallkomplexes mit dem Metall des Kontaktes gebunden werden. Überschüssiges Lösungsmittel und Phosphin kann anschließend entfernt werden, beispielsweise durch Spülen oder Abschleudern. Die Lösung des Phosphins kann mit üblichen Verfahren auf die Kontakte aufgebracht werden. Geeignet sind beispielsweise Sprüh- oder Tauchverfahren. Ebenso kann die Lösung des Phosphins auf die Oberfläche des Substrats und der Kontakte aufgeschleudert werden, wobei die Phosphinmoleküle selektiv an die Oberfläche der metallischen Kontakte gebunden werden. Schließlich ist es auch möglich, das Phosphin durch ein Druckverfahren auf die Kontakte aufzubringen. Nachdem die Kontakte mit der Lösung des Phosphins bedruckt sind, muss anschließend überschüssiges Lösungsmittel entfernt werden, beispielsweise durch Verdampfen. Um die Schicht des Phosphins nicht zu dick zu gestalten, muss dabei mit entsprechend verdünnten Lösungen gearbeitet werden. Der Begriff "Lösung" ist in diesem Fall weit auszulegen. Es ist nicht erforderlich, dass das Phosphin in vollständig gelöster Form als klare Lösung vorliegt. Es ist ebenfalls möglich, die Lösung in einer pastösen Form bereitzustellen. Die Anforderungen an die Konsistenz der Lösung werden Wesentlich von den Anforderungen bestimmt, die sich aus dem Verfahren ergeben, mit dem die Lösung auf den Flächen der Kontakte aufgebracht wird. Abschließend wird der organische Halbleiter abgeschieden, so dass eine Halbleiterstrecke zwischen erstem und zweitem Kontakt erhalten wird. Dazu werden ebenfalls übliche Verfahren verwendet. So kann beispielsweise Pentazen durch Sublimation im Vakuum abgeschieden werden. Es ist aber auch möglich, den organischen Halbleiter in gelöster Form aufzubringen. Geeignet ist beispielsweise eine Lösung von R,R-Poly-3-Hexylthiophen in Chloroform. Dazu kann die Lösung des organischen Halbleiters beispielsweise aufgesprüht oder aufgeschleudert werden. Ebenso ist es möglich, den organischen Halbleiter durch Drucktechniken aufzubringen.

Beim oben beschriebenen Verfahren zur Herstellung der erfindungsgemäßen Halbleiteranordnung kann das Phosphin selbst auf die gereinigte Fläche des Kontakts aufgebracht werden, der beispielsweise aus Palladium besteht. Es ist aber auch möglich, das Phosphin gebunden in einem Metallkomplex auf die Fläche des Kontakts aufzubringen. Wie bereits beschrieben stellt sich in Lösung ein Gleichgewicht ein, in dem die an das Metallatom gebundenen Phosphinliganden abdissoziieren können. Dies ermöglicht es, dass die Phosphinliganden entweder direkt mit dem Metallatomen des Kontakts einen Komplex ausbilden, oder dass zum Beispiel der verbleibende Metallkomplex eine Metall-Metall-Bindung zu einem Metallatom ausbildet, dass an der Oberfläche des Kontakts angeordnet ist. In den Metallkomplexen können die Phosphine sowohl nur an das zentrale Metallatom gebunden sein, wie auch verbrückend wirken. Beispiele für geeignete Metallkomplexe sind nachfolgend gezeigt.

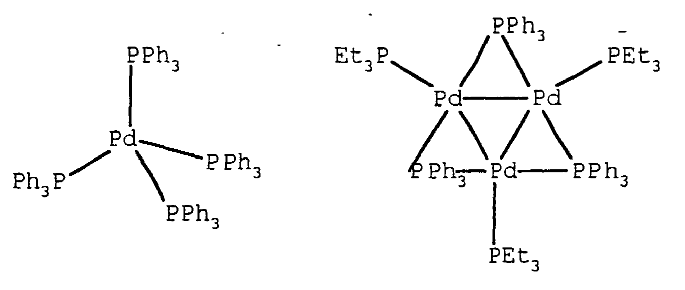

Bei der weiter oben beschriebenen Ausführungsform des Verfahrens wurden zunächst die Kontakte abgeschieden, und auf diesen, nach einer Behandlung mit dem Phosphin, die Schicht aus dem organischen Halbleitermaterial aufgebracht. An sich könnte auch zunächst die Schicht aus dem organischen Halbleitermaterial abgeschieden werden und erst auf dieser die Kontakte definiert werden. Im Allgemeinen ist es jedoch schwierig, eine Strukturierung der Kontakte durchzuführen, wenn diese auf der Schicht des organischen Halbleitermaterials angeordnet sind. Dies wirkt sich nachteilig auf die Leitfähigkeit bzw. die Ladungsträgerbeweglichkeit der organischen Halbleiterschicht sowie auf die Reproduzierbarkeit der Eigenschaften der dargestellten Halbleitereinrichtungen aus. Bevorzugt werden daher zunächst die Kontakte hergestellt und erst anschließend auf den Kontakten das organische Halbleitermaterial abgeschieden, um auf diese Weise die organische Halbleiterstrecke zu definieren.

Die Erfindung wird im Weiteren unter Bezugnahme auf eine beigefügte Zeichnung näher erläutert. Gleiche Gegenstände werden dabei mit gleichen Bezugszeichen bezeichnet. Es zeigt:

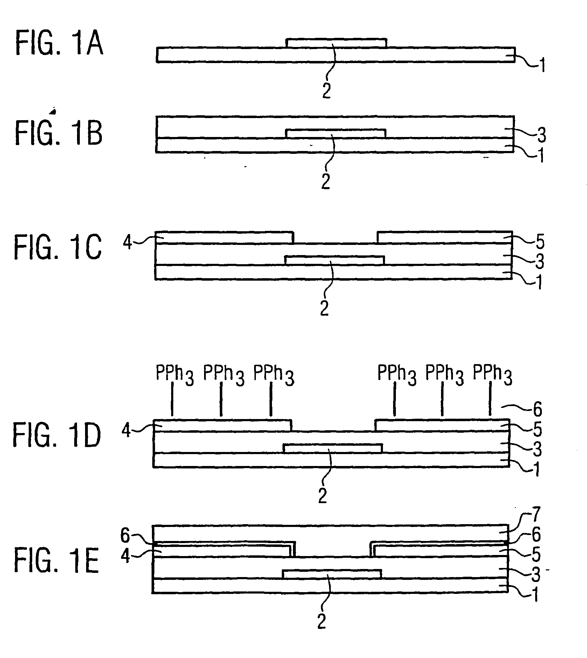

- Fig. 1: Verfahrensschritte, die bei der Herstellung eines Feldeffekttransistors durchlaufen werden, welcher die erfindungsgemäße Halbleitereinrichtung umfasst.

Fig. 1 zeigt eine Abfolge der Verfahrensschritte, die bei der Herstellung eines Feldeffekttransistors durchlaufen werden, welcher die erfindungsgemäße Halbleitereinrichtung umfasst. Zunächst wird, wie in Fig. 1A gezeigt, auf einem Substrat 1 eine Gateelektrode 2 definiert. Dazu wird auf dem Substrat 1, beispielsweise einer Polymerfolie, eine Schicht aus z.B. Palladium abgeschieden und anschließend durch fotolithografische Techniken strukturiert. Die Gateelektrode 2 wird anschließend isoliert, indem als Gatedielektrikum 3 eine Schicht aus beispielsweise Siliziumdioxid aufgebracht wird. Man erhält dadurch die in Fig. 1B dargestellte Anordnung. Auf dem Gatedielektrikum 3 werden nun die Sourceelektrode 4 und die Drainelektrode 5 definiert. Dazu wird, wie bei der Darstellung der Gateelektrode 2 beschrieben, zunächst eine Schicht aus z.B. Palladium abgeschieden und diese dann durch fotolithografische Techniken strukturiert, um wie in Fig. 1C dargestellt, Abschnitte aus Palladium zu erhalten, welche der Sourceelektrode 4 und der Drainelektrode 5 entsprechen. Auf die aus den Oberflächen der Sourceelektrode 4, der Drainelektrode 5 und des Gatedielektrikums 3 gebildete Oberfläche wird nun eine Lösung eines Phosphins in einem geeigneten Lösungsmittel aufgebracht und für eine bestimmte Zeitdauer dort belassen, so dass die Phosphinmoleküle aus der Lösung an die freiliegenden Flächen der Sourceelektrode 4 und der Drainelektrode 5 diffundieren können und dort gebunden werden. Abschließend wird überschüssiges Lösungsmittel sowie ungebundenes Phosphin entfernt, beispielsweise durch Spülen mit einem geeigneten Lösungsmittel und anschließendem Trocknen, beispielsweise einem Stickstoffstrom. Man erhält, wie in Fig. 1D dargestellt, eine Anordnung, in der an den Oberflächen der Sourceelektrode 4 und der Drainelektrode 5 Phosphinmoleküle gebunden sind, die eine monomolekulare Schicht 6 ausbilden. Abschließend wird, wie in Fig. 1E dargestellt, eine Schicht aus einem organischen Halbleiter 7 aufgebracht, welcher die mit der monomolekularen Schicht 6 versehenen Source- und Drainelektrode (4, 5) sowie den zwischen diesen Elektroden angeordneten Abschnitt des Gatedielektrikums 3 bedeckt.

### Beispiel 1

Eine flexible Polyethylennaphthalatfolie wird mit Aceton und Isopropanol gereinigt und anschließend auf der Folie eine dünne Schicht aus Titan abgeschieden. Die Titanschicht wird durch Fotolithografie und nasschemisches Ätzen in verdünnter Flusssäure strukturiert, um die Gateelektroden der Transistoren zu definieren. Anschließend wird durch Kathodenstrahlzerstäubung eine dünne Schicht Siliziumdioxid als Gatedielektrikum für die Transistoren abgeschieden und durch Fotolithografie sowie nasschemisches Ätzen strukturiert. Danach wird Palladium entweder durch thermisches Verdampfen, durch Elektronenstrahlverdampfen oder mittels Kathodenstrahlzerstäubung abgeschieden und ebenfalls durch Fotolithografie sowie nasschemisches Ätzen in einem stark verdünnten Gemisch aus Salzsäure und Salpetersäure geätzt, um die Source- und Drainkontakte der Transistoren zu definieren. Das so vorbereitete Substrat wird für 5 Minuten in eine 5 %-ige Lösung von Triphenylphosphin in Xylol getaucht, um die Palladiumoberflächen mit einer Monolage aus Triphenylphosphin zu bedecken. Überschüssiges Triphenylphosphin wird in einem Spülschritt mit Hexan abgespült. Nach dem Trocknen des Substrats wird mittels thermischen Verdampfens eine dünne Schicht Pentazen als organische Halbleiterschicht abgeschieden.

### Beispiel 2

Beispiel 1 wurde wiederholt, wobei jedoch anstelle einer Lösung von Triphenylphosphin in Xylol eine handelsübliche Lösung von Trimethylphosphin in Toluol verwendet wurde.

### Beispiel 3

Beispiel 1 wurde wiederholt, wobei jedoch anstelle von Triphenylphosphin Tetrakis(triphenylphosphino)palladium(0) verwendet wurde.

### Beispiel 4

Beispiel 1 wurde wiederholt, wobei jedoch anstelle von Triphenylphosphin Tetrakis(triphenylphosphino)platin(0) verwendet wurde.

## Patentansprüche

1. Halbleitereinrichtung mit einer Halbleiterstrecke aus einem organischen Halbleitermaterial, einem ersten Kontakt zum Injizieren von Ladungsträgern in die Halbleiterstrecke und einem zweiten Kontakt zum Extrahieren von Ladungsträgern aus der Halbleiterstrecke,
**dadurch gekennzeichnet,**
**dass** zwischen erstem Kontakt und der Halbleiterstrecke
und/oder zwischen zweitem Kontakt und der Halbleiterstrecke eine Schicht eines Phosphins angeordnet ist.

2. Halbleitereinrichtung nach Anspruch 1, wobei der erste und/oder zweite Kontakt aus Palladium aufgebaut ist.

3. Halbleitereinrichtung nach Anspruch 1 oder 2, wobei die Schichten des Phosphins als selbstorganisierende monomolekulare Schicht ausgebildet ist.

4. Halbleitereinrichtung nach einem der vorhergehenden Ansprüche, wobei das Phospin als Metallkomplex in der Schicht des Phosphins vorliegt.

5. Halbleitereinrichtung nach Anspruch 4, wobei der Metallkomplex Palladium(0) oder Platin(0) als Metall enthält.

6. Halbleitereinrichtung nach einem der vorhergehenden Ansprüche, wobei die Halbleitereinrichtung durch eine Gateelektrode und ein Gatedielektrikum zu einem Feldeffekttransistor ergänzt ist.

7. Verfahren zur Herstellung einer Halbleitereinrichtung nach einem der Ansprüche 1 bis 6, wobei auf einem Substrat ein erster und ein zweiter Kontakt bereitgestellt wird, von denen mindestens einer eine freiliegende Kontaktfläche aufweist, auf der freiliegenden Kontaktfläche ein Phosphin oder ein metallhaltiges Phosphinderivat aufgebracht wird, so dass auf der Kontaktfläche eine Schicht des Phosphins erhalten wird, und ein organisches Halbleitermaterial abgeschieden wird, so dass zwischen erstem Kontakt und zweitem Kontakt eine Halbleiterstrecke aus einem organischen Halbleitermaterial erhalten wird.

8. Verfahren nach Anspruch 7, wobei das Phosphin als Lösung auf der Kontaktfläche des ersten und/oder des zweiten Kontakts aufgebracht wird.

9. Verfahren nach einem der Ansprüche 7 oder 8, wobei das Phosphin in Form eines Metallkomplexes aufgebracht wird

## Claims

1. Semiconductor device having a semiconductor path comprising an organic semiconductor material, a first contact for injecting charge carriers into the semiconductor path and a second contact for extracting charge carriers from the semiconductor path, **characterized in that** a layer of a phosphine is arranged between the first contact and the semiconductor path and/or between the second contact and the semiconductor path.

2. Semiconductor device according to Claim 1, in which the first and/or second contact is composed of palladium.

3. Semiconductor device according to Claim 1 or 2, in which the layer of the phosphine is formed as a self-organizing monomolecular layer.

4. Semiconductor device according to one of the preceding claims, in which the phosphine is present as a metal complex in the layer of the phosphine.

5. Semiconductor device according to Claim 4, in which the metal complex contains palladium (0) or platinum (0) as metal.

6. Semiconductor device according to one of the preceding claims, which is supplemented by a gate electrode and a gate dielectric to form a field-effect transistor.

7. Method for fabricating the semiconductor device according to one of Claims 1 to 6, in which a first and a second contact, of which at least one has an uncovered contact surface, is provided on a substrate, to which uncovered contact surface a phosphine or a metal-containing phosphine derivative is applied, so that a layer of the phosphine is obtained on the contact surface, and an organic semiconductor material is deposited, so that a semiconductor path comprising an organic semiconductor material is obtained between the first contact and the second contact.

8. Method according to Claim 7, in which the phosphine is applied to the contact surface of the first and/or second contact as a solution.

9. Method according to either of Claims 7 and 8, in which the phosphine is applied in the form of a metal complex.

## Revendications

1. Dispositif à semi-conducteur, comprenant une section semi-conductrice en un matériau semi-conducteur organique, un premier contact pour injecter des porteurs de charge dans la section semi-conductrice et un deuxième contact pour extraire des porteurs de charge de la section semi-conductrice,
**caractérisé**
**en ce qu'**une couche d'une phosphine est disposée entre le premier contact et la section semi-conductrice et/ou entre le deuxième contact et la section semi-conductrice.

2. Dispositif à semi-conducteur suivant la revendication 1, dans lequel le premier et/ou le deuxième contact est en palladium.

3. Dispositif à semi-conducteur suivant la revendication 1 ou 2, dans lequel la couche de la phosphine est constituée sous la forme d'une couche monomoléculaire à auto-organisation.

4. Dispositif à semi-conducteur suivant l'une des revendications précédentes, dans lequel la phosphine se présente sous la forme d'un complexe métallique dans la couche de la phosphine.

5. Dispositif à semi-conducteur suivant la revendication 4, dans lequel le complexe métallique contient comme métal du palladium (0) ou du platine (0).

6. Dispositif à semi-conducteur suivant l'une des revendications précédentes, dans lequel le dispositif à semi-conducteur est complété par une électrode de grille et un diélectrique de grille en un transistor à effet de champ.

7. Procédé de fabrication d'un dispositif à semi-conducteur suivant l'une des revendications 1 à 6, dans lequel on prépare sur un substrat un premier et un deuxième contact dont l'un au moins a une surface de contact dégagée, on dépose une phosphine ou un dérivé de phosphine métallifère sur la surface de contact dégagée, de façon à ce qu'une couche de phosphine soit contenue sur la surface de contact et on dépose un matériau semi-conducteur organique de façon à obtenir une section semi-conductrice en un matériau semi-conducteur organique entre le premier contact et le deuxième contact.

8. Procédé suivant la revendication 7, dans lequel on dépose la phosphine sous la forme d'une solution sur la surface de contact du premier et/ou du deuxième contact.

9. Procédé suivant l'une des revendications 7 ou 8, dans lequel on dépose la phosphine sous la forme d'un complexe métallique.
